(19) Europäisches Patentamt
European Patent Office
Office européen des brevets

(11) **EP 4 439 033 B1**

(12) **EUROPEAN PATENT SPECIFICATION**

(45) Date of publication and mention
of the grant of the patent:
**18.03.2026 Bulletin 2026/12**

(21) Application number: **23740113.8**

(22) Date of filing: **17.01.2023**

(51) International Patent Classification (IPC):
*G01L 19/00* (2006.01)   *C23C 14/14* (2006.01)
*C23C 14/54* (2006.01)   *G01L 9/00* (2006.01)

(52) Cooperative Patent Classification (CPC):
**G01L 27/002; C23C 14/14; C23C 14/543;
G01L 9/0001; G01L 9/0089;** Y02E 30/30

(86) International application number:
**PCT/CN2023/072543**

(87) International publication number:
**WO 2023/134772 (20.07.2023 Gazette 2023/29)**

(54) **METAL VAPOUR PRESSURE DETECTION APPARATUS AND DETECTION METHOD**

METALLDAMPFDRUCKDETEKTIONSVORRICHTUNG UND DETEKTIONSVERFAHREN

APPAREIL DE DÉTECTION DE PRESSION DE VAPEUR DE MÉTAL ET PROCÉDÉ DE DÉTECTION

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **17.01.2022 CN 202210048695**

(43) Date of publication of application:
**02.10.2024 Bulletin 2024/40**

(73) Proprietor: **BAOSHAN IRON & STEEL CO., LTD.**
**Shanghai 201900 (CN)**

(72) Inventors:
• **JIN, Xiaoli**
**Shanghai 201900 (CN)**
• **ZHOU, Yueming**
**Shanghai 201900 (CN)**
• **LI, Shanqing**
**Shanghai 201900 (CN)**
• **ZHANG, Chunwei**
**Shanghai 201900 (CN)**

• **XIONG, Fei**
**Shanghai 201900 (CN)**
• **WANG, Yiru**
**Shanghai 201900 (CN)**

(74) Representative: **Maiwald GmbH**
**Elisenhof**
**Elisenstraße 3**
**80335 München (DE)**

(56) References cited:
**EP-B1- 2 230 326      CN-A- 106 490 968
CN-A- 106 618 172      CN-A- 112 538 603
CN-A- 112 747 791      CN-A- 113 483 937
JP-A- 2001 033 232**

• **ANONYMOUS: "Intrumentation-Electronics
Pressure Transducer", 24 September 2011
(2011-09-24), XP093248899, Retrieved from the
Internet <URL:https://web.archive.org/web/
20110924231735/http://www.
instrumentationtoday.com/pressure-transducer/
2011/09/>**

# Description

## TECHNICAL FIELD

The present invention belongs to the technical field of metal vapour detection, and particularly relates to a metal vapour pressure detection apparatus and detection method.

## BACKGROUND

Physical vapor deposition (PVD) is a widely used material surface treatment technology that evaporates metals, alloys, or compounds in a vacuum environment, causing the formed metal vapour to condense and deposit on a substrate. Coating the surface of a material by using this technology enables a coating to have better wear resistance, corrosion resistance, and dry lubrication, as well as high hardness, which can significantly improve the performance and service life of the material. This technology is environmentally friendly and widely used in the fields of machinery, electronics, hardware, aerospace, chemical industry, etc., making it an important application technology in green manufacturing.

In the application of the physical vapor deposition technology, a variety of coating materials, such as zinc, aluminum, magnesium, and chromium can be used. The coating speed is generally fast, typically up to 1-3 m/s. In order to obtain a better coating surface quality and spraying effect, it is required to maintain a relatively constant metal vapour flow rate and pressure of metal vapour during the spraying process. The pressure of metal vapour is critical for controlling the spraying process and is one of the key parameters that determine the bonding strength between the coating and the substrate.

At present, common pressure detection devices are mainly suitable for gases and water vapour. Since metal vapor is a high-temperature airflow, it easily condenses in low temperature regions, and some metals are relatively reactive and can easily react with other metals to corrode them. Therefore, existing pressure detection devices cannot directly obtain the pressure of metal vapour. At present, there are few reports on metal vapour pressure detection methods, and most of them use indirect methods for pressure measurement.

CN 112 538 603 A discloses a metal vapour coating system in which a non-specified pressure detection element is used to detect a pressure inside an evaporation crucible that is sufficient for metal vapour deposition.

After literature research and patent searches, there is currently no method or apparatus for directly measuring metal vapour pressure. Therefore, it is necessary to develop a measurement method and apparatus that can directly obtain the metal vapour pressure to provide a basis for online control and adjustment of metal vapour.

## SUMMARY

To address the above deficiencies existing in the prior art, the present invention provides a metal vapour pressure detection apparatus and detection method. By setting up a displacement generation system and a displacement detection system on an outer side of a metal evaporation cavity, and the pressure of metal vapour is directly measured according to a displacement of a displacement slider detected in real time and a relationship curve between a pressure and the displacement obtained by gas calibration, providing a basis for online control and adjustment of metal vapour.

To achieve the above object, the present invention adopts the following technical solutions:

The first aspect of the present invention provides a metal vapour pressure detection apparatus, including a metal evaporation cavity and a pressure detection mechanism disposed on an outer side of the metal evaporation cavity, wherein
the metal evaporation cavity is used to melt and evaporate metal to form metal vapour; and
the pressure detection mechanism includes a displacement generation system and a displacement detection system disposed on the displacement generation system; the displacement generation system includes a displacement slider sleeve, a displacement slider disposed in the displacement slider sleeve, and a pressure balance spring connected to the displacement slider, the displacement slider sleeve is in communication with the metal evaporation cavity, and the displacement slider slides along the displacement slider sleeve under a pressure of the metal vapour; one end of the pressure balance spring is connected to the displacement slider, and the other end is connected to the displacement detection system; and the pressure detection mechanism determines the pressure of the metal vapour according to coordinates of the displacement slider detected by the displacement detection system, and the displacement generation system further includes a heater disposed in the displacement slider sleeve.

Preferably, the displacement detection system includes a fixed bracket and a displacement sensor; the fixed bracket is provided with a spring limiting block connected to the pressure balance spring, a fixing ring sleeved on the displacement slider sleeve, and a sensor fixing block for mounting the displacement sensor; and the spring limiting block is disposed between the fixing ring and the sensor fixing block, and the spring limiting block is provided with a light-transmitting hole corresponding to the displacement sensor.

Preferably, the pressure balance spring is composed of 1-10 springs, with a wire diameter of 0.1-6 mm.

Preferably, a center of the displacement sensor, a center of the light-transmitting hole, and a center of the pressure balance spring are on the same axis.

Preferably, the pressure detection mechanism further includes an intelligent processing module; and the intelligent processing module is used to receive the coordinates of the displacement slider detected by the displacement sensor, calculate a displacement of the displacement slider, and obtain the pressure of the metal vapour according to the displacement of the displacement slider and a relationship curve between the displacement and a pressure obtained by calibration.

The second aspect of the present invention provides a metal vapour pressure detection method, using the metal vapour pressure detection apparatus described above. The detection method includes the steps of:

S1, introducing gas with different pressures into a metal evaporation cavity of the metal vapour pressure detection apparatus for repeated calibration to obtain a relationship curve between a pressure and a displacement of a displacement slider;

S2, melting and evaporating metal to form metal vapour in the metal evaporation cavity, wherein the displacement slider slides along a displacement slider sleeve under a pressure of the metal vapour, and a pressure balance spring gradually contracts under extrusion of the displacement slider until the displacement slider reaches a force equilibrium and stops moving, and a displacement detection system detects coordinates of the displacement slider in real time to obtain a displacement of the displacement slider; and

S3, obtaining the pressure of the metal vapour according to the relationship curve between the pressure and the displacement of the displacement slider obtained in the step S1 and the displacement of the displacement slider obtained in the step S2.

Preferably, in the step S1, the gas has a pressure of $1\times10^3$-$1\times10^5$ Pa.

Preferably, in the step S2, the displacement $\Delta S$ of the displacement slider is:

$$\Delta S=|S_t-S_0|$$

wherein $\Delta S$ is the displacement of the displacement slider, in mm;

$S_t$ represents coordinates of the displacement slider when it reaches a force equilibrium after moving, in mm; and

$S_0$ represents coordinates of the displacement slider at a zero position (the initial coordinate of the displacement slider), in mm.

Preferably, in the step S2, the displacement slider sleeve is heated by a heater to a temperature of 20-1000°C during movement of the displacement slider.

The metal vapour pressure detection apparatus and detection method provided by the present invention have the following beneficial effects:

1. The metal vapour pressure detection apparatus and detection method of the present invention, through the displacement generation system and the displacement detection system disposed on the outer side of the metal evaporation cavity, directly measure the pressure of the metal vapour based on the displacement of the displacement slider detected in real time and the relationship curve between the pressure and the displacement obtained by gas calibration, thereby providing a basis for online control and adjustment of metal vapour.

2. The metal vapour pressure detection apparatus and detection method of the present invention can monitor the metal vapour pressure in a temperature range from normal temperature to 1000°C in real time, providing a stable detection and adjustment basis for metal evaporation control.

3. The metal vapour pressure detection apparatus and detection method of the present invention are suitable for directly obtaining pressures of various metal vapours, featuring good structural adaptability and process compatibility.

4. The metal vapour pressure detection apparatus of the present invention is simple in structure, suitable for various operating conditions and environments, cost-effective, easy to operate and maintain, and facilitates automatic interlocking control.

## BRIEF DESCRIPTION OF THE DRAWINGS

Figure 1 is a structural schematic diagram of a metal vapour pressure detection apparatus according to the present invention.

Figure 2a is a structural schematic diagram of a pressure detection mechanism according to the present invention.

Figure 2b is a sectional view taken along line A-A of Figure 2a.

Figure 3a is a schematic diagram showing a displacement slider of the pressure detection mechanism of the present invention under the action of metal vapour pressure.

Figure 3b is a sectional view taken along line B-B of Figure 3a.

Figure 4 is a structural schematic diagram of a fixed bracket according to the present invention.

Figure 5a is a structural schematic diagram of a displacement slider sleeve according to the present invention.

Figure 5b is a sectional view taken along line C-C of Figure 5a.

Figure 6 is a structural schematic diagram of a pressure balance spring composed of multiple springs having different specifications, such as wire diameters.

Reference signs:
1-metal evaporation cavity, 2-metal evaporation area, 3-pressure detection mechanism, 4-displacement slider, 5-displacement slider sleeve, 6-pressure balance spring, 7-fixed bracket (7-1 spring limiting block; 7-2 sensor fixing block; 7-3 fixing ring), 8-displacement sensor, and 9-heater.

## DETAILED DESCRIPTION

In order to better understand the above technical solutions of the present invention, the technical solutions of the present invention are further illustrated below in conjunction with the following embodiments.

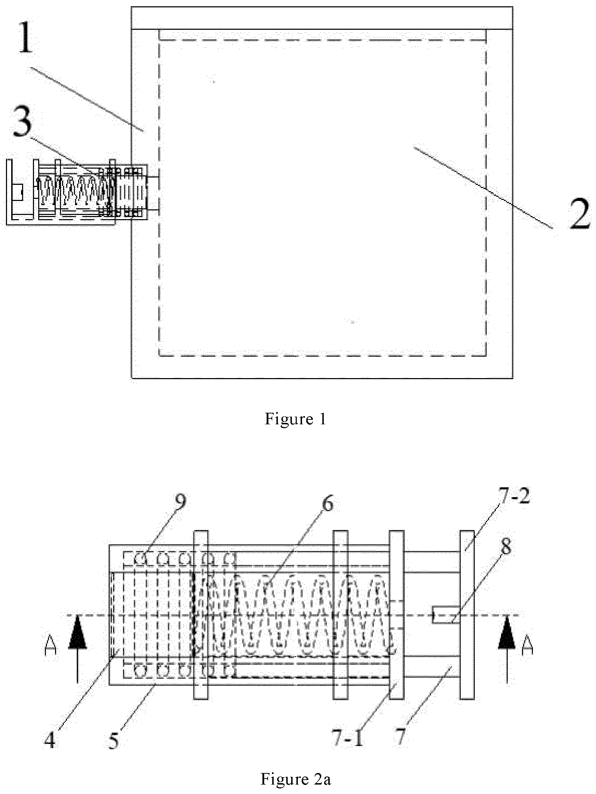

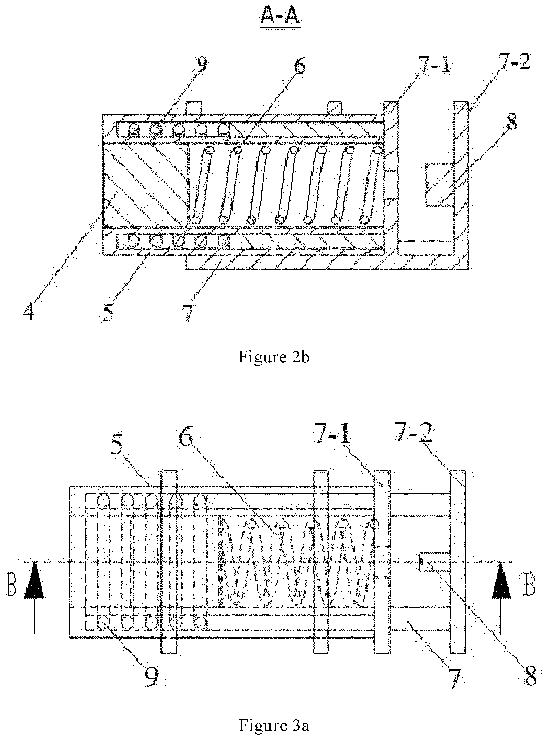

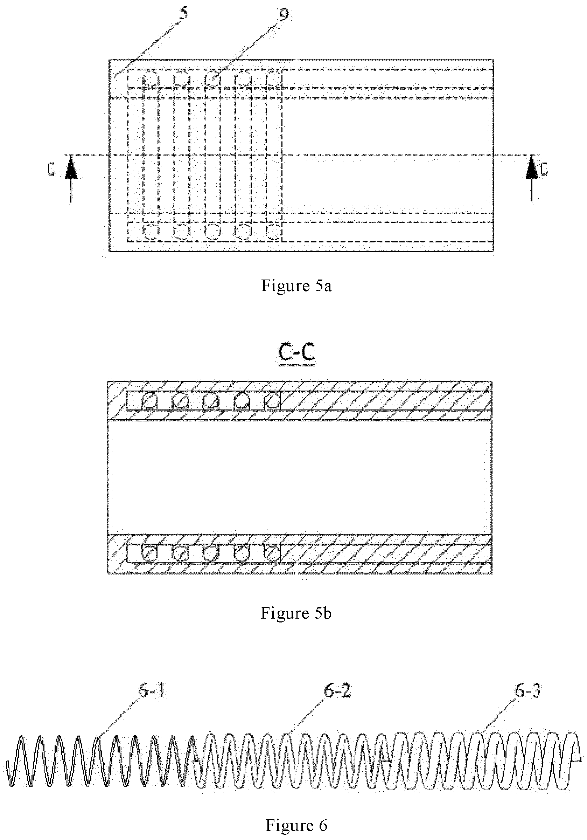

As shown in Figure 1, the present invention provides a metal vapour pressure detection apparatus, including a metal evaporation cavity 1 and a pressure detection mechanism 3 disposed on an outer side of the metal evaporation cavity 1. The metal evaporation cavity 1 is used to melt and evaporate metal to form metal vapour, with its interior being a metal evaporation area 2. As shown in Figures 2a and 2b, the pressure detection mechanism 3 includes a displacement generation system and a displacement detection system disposed on the displacement generation system. The displacement generation system includes a displacement slider sleeve 5 (as shown in Figures 5a and 5b), a displacement slider 4 disposed in the displacement slider sleeve 5, and a pressure balance spring 6 connected to the displacement slider 4. The displacement slider sleeve 5 is in communication with the metal evaporation cavity 1, and the displacement slider 4 slides radially along the displacement slider sleeve 5 under a pressure of the metal vapour. One end (movable end) of the pressure balance spring 6 is connected to the displacement slider 4, and the other end (fixed end) of the pressure balance spring 6 is connected to the displacement detection system. The pressure detection mechanism 3 calculates a displacement of the displacement slider 4 based on the coordinates of the displacement slider 4 detected by the displacement detection system, and thereby determines the pressure of metal vapour.

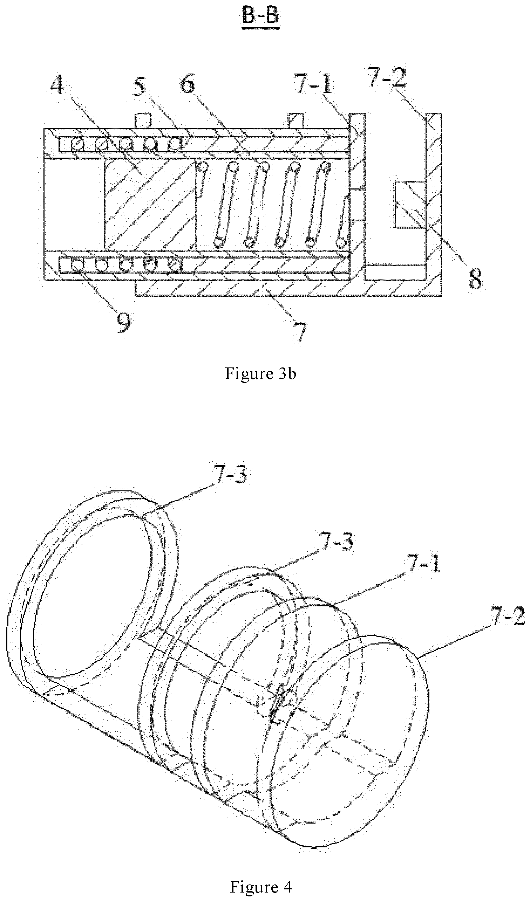

As shown in Figures 2a and 2b, the displacement detection system of the present invention further includes a fixed bracket 7 and a displacement sensor 8. As shown in Figure 4, the fixed bracket 7 is provided with a spring limiting block 7-1 connected to the pressure balance spring 6, a fixing ring 7-3 sleeved on the displacement slider sleeve 5, and a sensor fixing block 7-2 for mounting the displacement sensor 8. Two fixing rings 7-3 are arranged in order to make the fixed bracket more stable. The spring limiting block 7-1 is disposed between the fixing ring 7-3 and the sensor fixing block 7-2, and is provided with a light-transmitting hole corresponding to the displacement sensor 8. The fixed bracket 7 serves three functions: firstly, the position of the fixed end is defined by the spring limiting block 7-1 when the pressure balance spring 6 is deformed, and the light-transmitting hole corresponding to the displacement sensor 8 is designed in the spring limiting block 7-1, facilitating the displacement sensor 8 to perform real-time measurement on the coordinates of the displacement slider 4; secondly, the displacement sensor 8 is mounted on the sensor fixing block 7-2, which can measure the displacement of the displacement slider 4 under the action of metal vapour; and thirdly, the fixed bracket 7 is mounted on the displacement slider sleeve 5 through the fixing rings 7-3, making the fixed bracket 7 an important component connecting the displacement generation system and the displacement detection system.

In the present invention, a center of the displacement sensor 8, a center of the pressure balance spring 6, and a center of the light-transmitting hole are essentially on the same axis to ensure that the displacement sensor 8 is not obstructed by other components during the measurement.

As shown in Figures 2a and 2b, in order to prevent the metal vapour from condensing between the displacement slider 4 and the displacement slider sleeve 5, and on an inner wall of the displacement slider sleeve 5, which affects the metal vapour pressure detection effect, the displacement generation system further includes a heater 9 disposed within the displacement slider sleeve 5, which can heat the displacement slider sleeve 5 to a temperature above the metal vapour temperature. In the present invention, the heater 9 employs resistance heating or induction heating, with a heating temperature range of 20-1000°C.

As shown in Figure 6, in practical applications, a reasonable pressure balance spring 6 may be designed according to different pressure ranges. For example, when a metal vapour pressure detection range is $1 \times 10^3$-$10^5$ Pa, the pressure balance spring 6 may be composed of a single spring or multiple springs, thereby enabling a wide range of metal vapour pressure measurements. For example, in the present invention, the pressure balance spring 6 is composed of 1-10 springs. When the metal vapour pressure is measured by using a combination of multiple springs, the multiple springs are connected in series to form the pressure balance spring 6. For example, in Figure 6, three springs with different wire diameters (6-1, 6-2, and 6-3) are connected in series to form the pressure balance spring 6. In the pressure balance spring 6, a wire diameter of each spring can be designed according to a pressure range to be measured, with a selectable wire diameter between 0.1 mm and 6 mm.

In the present invention, the pressure detection mechanism 3 further includes an intelligent processing module. In the metal evaporation process, the intelligent processing module receives the coordinates of the displacement slider 4 measured in real time by the displacement sensor 8, calculates a displacement $\Delta S$ of the displacement slider 4, and obtains the pressure of the metal vapour according to the displacement $\Delta S$ and a relationship curve between a pressure and the displacement $\Delta S$ of the displacement slider 4 obtained by calibration, thereby obtaining the pressure of the metal vapour in real time.

The metal vapour pressure detection apparatus of the present invention can be used for measuring metal vapour pressure under both normal and vacuum conditions, making it suitable for measuring metal vapour pressure under various operating conditions. The metal vapour pressure detection apparatus of the present invention can directly obtain the pressure of the metal vapour, with minimal influence from other factors, and has a high anti-interference ability, and relatively stable pressure measurement.

When the metal vapour pressure detection apparatus of the present invention is in use, in the absence of metal vapour, the displacement slider 4 rests against the metal evaporation cavity 1 (an outer wall of the metal evaporation cavity 1 is provided with a limiting part to keep the displacement slider 4 within the displacement slider sleeve 5) under the compressive stress of the pressure balance spring 6, forming a force equilibrium. This position represents coordinates of the displacement slider 4 when it has not moved, referred to as a zero position $S_0$. As shown in Figures 3a and 3b, when metal vapour is generated (or other gases are introduced) in the metal evaporation cavity 1, as the evaporation process proceeds, the metal vapour pressure in the metal evaporation cavity 1 increases. When the metal vapour pressure exceeds the initial compressive stress of the pressure balance spring 6, the net external force on the displacement slider 4 is directed away from the metal evaporation cavity 1 (outward). The displacement slider 4 moves along a wall of the displacement slider sleeve 5 in a direction away from the metal evaporation cavity 1. The pressure balance spring 6 gradually contracts under extrusion of the displacement slider 4, and at the same time, its compressive stress to the displacement slider 4 gradually increases. When the compressive stress of the pressure balance spring 6 equals the pressure of the metal vapour, the displacement slider 4 reaches a force equilibrium and stops moving. During the metal evaporation process, the pressure of the metal vapour generated inside the metal evaporation cavity 1 decreases, when the pressure of the metal vapour is less than the compressive stress of the pressure balance spring 6, the net external force of the displacement slider 4 is directed towards the metal evaporation cavity 1 (inward). The displacement slider 4 moves towards the metal evaporation cavity 1, and the compressive stress of the pressure balance spring 6 on the displacement slider 4 gradually decreases. When the compressive stress of the pressure balance spring 6 on the displacement slider 4 equals the metal vapour pressure, the displacement slider 4 stops moving. When the metal evaporation is nearing completion and the metal vapour pressure continues to decrease, the displacement slider 4 moves toward the metal evaporation cavity 1 under the internal stress of the pressure balance spring 6 until it rests against the metal evaporation cavity 1, indicating that the metal vapour pressure is lower than the minimum detection pressure of the metal vapour pressure detection apparatus. During the movement of the displacement slider 4 from moving away from the metal evaporation cavity 1 to reaching force equilibrium and stopping, the coordinates of the displacement slider 4 are measured in real time by the displacement sensor 8 and transferred to the intelligent processing module, which can calculate the displacement $\Delta S$ of the displacement slider 4 in real time, and then determine the pressure of the metal vapour according to the displacement $\Delta S$ and the relationship curve between the pressure and the displacement obtained through gas calibration.

The pressure of the metal vapour is detected by using the metal vapour pressure detection apparatus described above, wherein a detection method includes the following steps:
S1, introduce gas with different pressures into a metal evaporation cavity of the metal vapour pressure detection apparatus for repeated calibration to obtain a relationship curve between a pressure and a displacement of a displacement slider.

The specific process is as follows: before a metal vapour pressure is obtained, a relationship between a pressure of the metal vapour pressure detection apparatus and the displacement of the displacement slider is first calibrated. Gas with a known pressure is introduced into the metal evaporation cavity, the displacement slider moves away from the metal evaporation cavity under the action of the gas, a pressure balance spring gradually contracts under extrusion of the displacement slider while exerting an inward compressive stress to the displacement slider until the displacement slider reaches a force equilibrium and stops moving. The displacement detection system measures coordinates of the displacement slider in real time. When no gas is introduced into the metal evaporation cavity, the displacement slider rests against the limiting part on the outer wall of the metal evaporation cavity under the action of the inward compressive stress of the pressure balance spring, forming a force equilibrium, and at this time, the position of the displacement slider is recorded as the zero position $S_0$. Based on the above process, obtain the relationship curve between the pressure and the displacement of the displacement slider. In order to ensure the accuracy of data, repeated calibrations are required. Additionally, the pressure of the gas also needs to be increased or decreased to perform multiple repeated calibrations of the relationship between the pressure and the displacement of the displacement slider for a plurality of times to obtain the relationship curve between the pressure and the displacement of the displacement slider. The gas used during calibration has a pressure of $1 \times 10^3$-$1 \times 10^5$ Pa.

S2, melt and evaporate the metal to form metal vapour in the metal evaporation cavity. The displacement slider slides along a displacement slider sleeve under a pressure of the metal vapour. The pressure balance spring gradually contracts under extrusion of the displacement slider until the displacement slider reaches a force equilibrium and stops moving. The displacement detection system detects coordinates of the displacement slider in real time to obtain a displacement of the displacement slider.

The specific process is as follows: melt and evaporate the metal to form the metal vapour in the metal evaporation cavity. When the pressure of the metal vapour exceeds an initial internal stress of the pressure balance spring, the displacement slider slides along the displacement slider sleeve under the pressure of the metal vapour. The pressure balance spring gradually contracts under the extrusion of the displacement slider. When the internal stress of the pressure balance spring to the displacement slider equals the pressure of the metal vapour, the displacement slider stops moving. The displacement detection system detects coordinates $S_t$ of the displacement slider at this time in real time and sends them to a pressure detection system to obtain the displacement $\Delta S$ of the displacement slider:

$$\Delta S = |S_t - S_0|$$

wherein $\Delta S$ is the displacement of the displacement slider, in mm;

$S_t$ represents coordinates of the displacement slider when it reaches a force equilibrium and stops moving after moving, in mm; and

$S_0$ represents coordinates of the displacement slider at a zero position, in mm.

When the pressure of the metal vapour changes, the displacement at this time can be recalculated based on the coordinates detected by the displacement detection system after the displacement slider reaches a force equilibrium again.

In the above process, in order to prevent the metal vapour from condensing between the displacement slider and the displacement slider sleeve and on the inner wall of the displacement slider sleeve, which would affect the metal vapour pressure detection effect, the displacement slider sleeve is heated by a heater to a temperature of 20-1000°C.

S3, obtain the pressure of the metal vapour according to the relationship curve between the pressure and the displacement of the displacement slider obtained in the step S1 and the displacement obtained in the step S2.

The specific process is as follows: the pressure of the metal vapour is obtained in real time according to the relationship curve between the pressure and the displacement of the displacement slider obtained in the step S1 and the displacement detected in the step S2.

The metal vapour pressure detection apparatus and detection method of the present invention are further described below with reference to specific examples.

**Example 1**

In this example, the metal vapour pressure to be measured is in the range of $5 \times 10^3$-$1 \times 10^5$ Pa, and the pressure balance spring 4 is composed of a single spring with a wire diameter of 4-6 mm. The implementation steps are as follows:

First, the metal vapour pressure detection apparatus is calibrated as follows:

In an initial state, the displacement sensor 8 records coordinates $S_0$ of an initial zero position of the displacement slider 4 and sends them to the intelligent processing module.

Introduce nitrogen gas into the metal evaporation cavity 1. As the pressure of the nitrogen gas in the metal evaporation cavity 1 increases, the displacement slider 4 moves outward under the net external force. The pressure of the nitrogen gas in the cavity can be measured by a pressure gauge, and the displacement sensor 8 can detect the displacement of the displacement slider 4 in real time to obtain a relationship between the displacement and the pressure during the increase of the gas pressure.

When the pressure of the nitrogen gas in the metal evaporation cavity reaches $1 \times 10^5$ Pa, gradually reduce the pressure of the nitrogen in the metal evaporation cavity to $5 \times 10^3$ Pa. During this process, as the pressure of the gas acting on the displacement slider 4 decreases, the net external force becomes inward. Measure the real-time displacement of the displacement slider 4 to obtain a relationship between the displacement and the pressure during the decrease of the gas pressure.

Throughout the calibration process, the displacement of the displacement slider 4 and a corresponding value of the gas pressure in the metal evaporation cavity are sent to the intelligent processing module in real time. By repeating the measurement for a plurality of times, a relationship curve between the displacement and the pressure is obtained.

Then, the metal vapour pressure in the metal evaporation cavity is obtained by using the relationship curve between the displacement and the pressure from the above calibration.

Record the initial zero position of the displacement slider in an initial state of metal melting and evaporation and send it to the intelligent processing module.

Heat the metal in the metal evaporation cavity 1 to achieve melting and evaporation and measure the temperature of a metal melting and evaporation area in real time, send it to the intelligent processing module.

The intelligent processing module sends the real-time temperature inside the metal evaporation cavity 1 to the heater 9, which heats the displacement slider sleeve 5 to a target temperature (greater than or equal to the metal vapour temperature) to avoid condensation of the metal vapour on the pressure detection apparatus.

The displacement sensor 8 detects the displacement generated by the displacement slider 4 in real time. The real time pressure of the metal vapour in the metal evaporation cavity 1 is determined using the relationship curve between the displacement and pressure obtained from the calibration.

Using the above method, stable measurement of the metal vapour pressure in a range of $5\times10^3$-$1\times10^5$ Pa can be achieved.

## Example 2

In this example, the metal vapour pressure to be measured is in the range of $1\times10^3$-$5\times10^3$ Pa, and the pressure balance spring 4 is composed of a single spring with a wire diameter of 2-5 mm. The specific implementation method and steps are the same as those in Example 1.

## Example 3

In this example, the metal vapour pressure to be measured is in the range of $1\times10^3$-$5\times10^3$ Pa, and the pressure balance spring 4 is composed of two or more springs with different wire diameters in series, with wire diameters of 0.1-5 mm. This allows for high-precision metal vapour pressure detection.

In summary, in the present invention, the displacement generation system and the displacement detection system are disposed on the outer side of the metal evaporation cavity, and the pressure of metal vapour is directly obtained according to the displacement of the displacement slider detected in real time and the relationship curve between the pressure and the displacement obtained by gas calibration, providing a basis for online control and adjustment of metal vapour. The metal vapour pressure detection apparatus and detection method of the present invention can monitor the metal vapour pressure in a temperature range from normal temperature to 1000°C in real time, providing a stable detection and adjustment basis for metal evaporation control. The metal vapour pressure detection apparatus and detection method of the present invention are suitable for detecting pressures of various metal vapours, with good structural flexibility and process compatibility. The metal vapour pressure detection apparatus of the present invention is simple in structure, suitable for various operating conditions and environments, and particularly suitable for metal vapour pressure detection under vacuum conditions. It is cost-effective, easy to operate and maintain, and facilitates automatic interlocking control.

It will be appreciated by those skilled in the art that the above examples are merely illustrative of the present invention and are not intended to limit it. The matter for which protection is sought is defined by the appended claims.

## Claims

1. A metal vapour pressure detection apparatus, wherein the detection apparatus comprises a metal evaporation cavity (1) and a pressure detection mechanism (3) disposed on an outer side of the metal evaporation cavity (1), wherein

   the metal evaporation cavity (1) is used to melt and evaporate metal to form metal vapour;
   **characterized in that** the pressure detection mechanism (3) comprises a displacement generation system and a displacement detection system disposed on the displacement generation system; the displacement generation system comprises a displacement slider sleeve (5), a displacement slider (4) disposed in the displacement slider sleeve (5), and a pressure balance spring (6) connected to the displacement slider (4); the displacement slider sleeve (5) is in communication with the metal evaporation cavity (1), and the displacement slider (4) slides along the displacement slider sleeve (5) under a pressure of the metal vapour; one end of the pressure balance spring (6) is connected to the displacement slider (4), and the other end is connected to the displacement detection system; and the pressure detection mechanism (3) determines the pressure of the metal vapour according to coordinates of the displacement slider (4) detected by the displacement detection system,
   and **in that** the displacement generation system further comprises a heater (9) disposed in the displacement slider sleeve (5).

2. The metal vapour pressure detection apparatus according to claim 1, wherein the displacement detection system further comprises a fixed bracket (7) and a displacement sensor (8); the fixed bracket (7) is provided with a spring limiting block (7-1) connected to the pressure balance spring (6), a fixing ring (7-3) sleeved on the displacement slider sleeve (5), and a sensor fixing block (7-2) for mounting the displacement sensor (8); and the spring limiting block (7-1) is disposed between the fixing ring (7-3) and the sensor fixing block (7-2), and the spring limiting block (7-1) is provided with a light-transmitting hole corresponding to the displacement sensor (8).

3. The metal vapour pressure detection apparatus according to claim 1, wherein the pressure balance spring (6) is composed of 1-10 springs, with a wire diameter of 0.1-6 mm.

**4.** The metal vapour pressure detection apparatus according to claim 2, wherein a center of the displacement sensor (8), a center of the light-transmitting hole, and a center of the pressure balance spring (6) are on the same axis.

**5.** The metal vapour pressure detection apparatus according to claim 2, wherein the pressure detection mechanism further comprises an intelligent processing module; and the intelligent processing module is used to receive the coordinates of the displacement slider (4) detected by the displacement sensor (8), to calculate a displacement of the displacement slider (4), and to obtain the pressure of the metal vapour according to the displacement of the displacement slider (4) and a relationship curve between the displacement and a pressure obtained by calibration.

**6.** A metal vapour pressure detection method, wherein the metal vapour pressure detection apparatus according to any one of claims 1 to 5 is used to detect a metal vapour pressure, wherein the detection method comprises the steps of:

S1, introducing gas with different pressures into a metal evaporation cavity (1) of the metal vapour pressure detection apparatus for repeated calibration to obtain a relationship curve between a pressure and a displacement of a displacement slider (4);

S2, melting and evaporating metal to form metal vapour in the metal evaporation cavity (1), wherein the displacement slider (4) slides along a displacement slider sleeve (5) under a pressure of the metal vapour, and a pressure balance spring (6) gradually contracts under extrusion of the displacement slider (4) until the displacement slider (4) reaches a force equilibrium and stops moving, and a displacement detection system detects coordinates of the displacement slider (4) in real time to obtain a displacement of the displacement slider (4); and

S3, obtaining the pressure of the metal vapour according to the relationship curve between the pressure and the displacement of the displacement slider (4) obtained in the step S1 and the displacement of the displacement slider (4) obtained in the step S2.

**7.** The metal vapour pressure detection method according to claim 6, wherein in the step S1, the gas has a pressure of $1 \times 10^3$-$1 \times 10^5$ Pa.

**8.** The metal vapour pressure detection method according to claim 6, wherein in the step S2, the displacement $\Delta S$ of the displacement slider (4) is:

$$\Delta S = |S_t - S_0|$$

wherein $\Delta S$ is the displacement of the displacement slider (4), in mm;
$S_t$ represents coordinates of the displacement slider (4) when it reaches a force equilibrium after moving, in mm; and
$S_0$ represents coordinates of the displacement slider (4) at a zero position, in mm.

**9.** The metal vapour pressure detection method according to claim 6, wherein in the step S2, the displacement slider sleeve (5) is heated by a heater (9) to a temperature of 20-1000°C during movement of the displacement slider (4).

**Patentansprüche**

**1.** Metall-Dampfdruck-Erfassungsvorrichtung, wobei die Erfassungsvorrichtung einen Metallverdampfungskavität (1) und einen Druckerfassungsmechanismus (3) umfasst, der an einer Außenseite der Metallverdampfungskavität (1) angeordnet ist, wobei

der Metallverdampfungskavität (1) zum Schmelzen und Verdampfen von Metall verwendet wird, um Metalldampf zu bilden; **dadurch gekennzeichnet, dass** der Druckerfassungsmechanismus (3) ein Verschiebungserzeugungssystem und ein Verschiebungserfassungssystem umfasst, das auf dem Verschiebungserzeugungssystem angeordnet ist; das Verschiebungserzeugungssystem eine Verdrängungsschiebehülse (5), einen in der Verdrängungsschiebehülse (5) angeordneten Verdrängungsschieber (4) und eine mit dem Verdrängungsschieber (4) verbundene Druckausgleichsfeder (6) umfasst; die Verdrängungsschiebehülse (5) mit dem Metallverdampfungshohlraum (1) in Verbindung steht und der Verdrängungsschieber (4) unter dem Druck des Metalldampfs entlang der Verdrängungsschiebehülse (5) gleitet; ein Ende der Druckausgleichsfeder (6) ist mit dem Verdrängungsschieber (4) verbunden, und das andere Ende ist mit dem Verdrängungserfassungssystem verbunden; und der Druckerfassungsmechanismus (3) bestimmt den Druck des Metalldampfes anhand der Koordinaten des Verdrängungsschiebers (4), die vom Verdrängungserfassungssystem erfasst werden, und dass das Verschiebungserzeugungssystem ferner eine Heizvorrichtung (9) umfasst, die in der Verdrängungsschiebehülse (5) angeordnet ist.

2. Metall-Dampfdruck-Erfassungsvorrichtung nach Anspruch 1, wobei das Metall-Dampfdruck-Erfassungsvorrichtung ferner eine feste Halterung (7) und einen Verdrängungssensor (8) umfasst; wobei die feste Halterung (7) mit einem mit der Druckausgleichsfeder (6) verbundenen Federbegrenzungsblock (7-1), einem auf die Verdrängungsschiebehülse (5) aufgeschobenen Befestigungsring (7-3) und einem Sensorbefestigungsblock (7-2) zum Anbringen des Verdrängungssensors (8) versehen ist; und der Federbegrenzungsblock (7-1) zwischen dem Befestigungsring (7-3) und dem Sensorbefestigungsblock (7-2) angeordnet ist, und der Federbegrenzungsblock (7-1) mit einer lichtdurchlässigen Öffnung versehen ist, die dem Verdrängungssensor (8) entspricht.

3. Metall-Dampfdruck-Erfassungsvorrichtung nach Anspruch 1, wobei die Druckausgleichsfeder (6) aus 1-10 Federn mit einem Drahtdurchmesser von 0,1-6 mm besteht.

4. Metall-Dampfdruck-Erfassungsvorrichtung nach Anspruch 2, wobei ein Mittelpunkt des Verdrängungssensors (8), ein Mittelpunkt der lichtdurchlässigen Öffnung und ein Mittelpunkt der Druckausgleichsfeder (6) auf derselben Achse liegen.

5. Metall-Dampfdruck-Erfassungsvorrichtung nach Anspruch 2, wobei der Druckerfassungsmechanismus ferner ein intelligentes Verarbeitungsmodul umfasst; und das intelligente Verarbeitungsmodul dazu verwendet wird, die vom Wegsensor (8) erfassten Koordinaten des Verdrängungsschiebers (4) zu empfangen, eine Verschiebung des Verdrängungsschiebers (4) zu berechnen und den Druck des Metalldampfes gemäß der Verschiebung des Verdrängungsschiebers (4) und einer durch Kalibrierung erhaltenen Beziehungskurve zwischen der Verschiebung und einem Druck zu ermitteln.

6. Verfahren zur Erfassung des Metalldampfdrucks, wobei die Metalldampfdruck-Erfassungsvorrichtung gemäß einem der Ansprüche 1 bis 5 verwendet wird, um einen Metalldampfdruck zu erfassen, wobei das Erfassungsverfahren die folgenden Schritte umfasst:

S1, Einleiten von Gas mit unterschiedlichen Drücken in einen Metallverdampfungskavität (1) der Metalldampfdruck-Erfassungsvorrichtung zur wiederholten Kalibrierung, um eine Beziehungskurve zwischen einem Druck und einer Verschiebung eines Verdrängungsschiebers (4) zu erhalten;
S2, Schmelzen und Verdampfen von Metall, um Metalldampf in der Metallverdampfungskavität (1) zu bilden, wobei der Verdrängungsschieber (4) unter dem Druck des Metalldampfs entlang einer Verdrängungsschiebehülse (5) gleitet, und eine Druckausgleichsfeder (6) sich unter dem Druck des Verschiebungsschiebers (4) allmählich zusammenzieht, bis der Verdrängungsschieber (4) ein Kräftegleichgewicht erreicht und seine Bewegung stoppt, und ein Verschiebungserfassungssystem die Koordinaten des Verdrängungsschiebers (4) in Echtzeit erfasst, um eine Verschiebung des Verdrängungsschiebers (4) zu erhalten; und
S3, Ermitteln des Drucks des Metalldampfs gemäß der Beziehungskurve zwischen dem Druck und der Verschiebung des Verdrängungsschiebers (4), die in Schritt S1 ermittelt wurde, und der Verschiebung des Verdrängungsschiebers (4), die in Schritt S2 ermittelt wurde.

7. Verfahren zur Erfassung des Metalldampfdrucks gemäß Anspruch 6, wobei in Schritt S1 das Gas einen Druck von $1 \times 10^3$ - $1 \times 10^5$ Pa aufweist.

8. Verfahren zur Erfassung des Metalldampfdrucks gemäß Anspruch 6, wobei in Schritt S2 die Verschiebung $\Delta S$ des Verschiebungsschiebers (4) wie folgt berechnet wird:

$$\Delta S = |S_t - S_0|$$

wobei $\Delta S$ die Verschiebung des Verschiebungsschiebers (4) in mm ist;
$S_t$ die Koordinaten des Verdrängungsschiebers (4) in mm darstellt, wenn dieser nach seiner Bewegung ein Kräftegleichgewicht erreicht, und $S_0$ die Koordinaten des Verdrängungsschiebers (4) in einer Nullposition in mm darstellt.

9. Verfahren zur Erfassung des Metalldampfdrucks gemäß Anspruch 6, wobei in Schritt S2 die Verdrängungsschiebehülse (5) während der Bewegung des Verdrängungsschiebers (4) durch eine Heizvorrichtung (9) auf eine Temperatur von 20 bis 1000 °C erwärmt wird.

**Revendications**

1. Appareil de détection de pression de vapeur métallique, dans lequel l'appareil de détection comprend une cavité d'évaporation métallique (1) et un mécanisme de détection de pression (3) disposé sur un côté extérieur de la cavité d'évaporation métallique (1), dans lequel

la cavité d'évaporation métallique (1) est utilisée pour faire fondre et évaporer du métal pour former de la vapeur métallique ;

**caractérisé en ce que** le mécanisme de détection de pression (3) comprend un système de génération de déplacement et un système de détection de déplacement disposé sur le système de génération de déplacement ; le système de génération de déplacement comprend un manchon coulissant de déplacement (5), un curseur de déplacement (4) disposé dans le manchon coulissant de déplacement (5), et un ressort d'équilibrage de pression (6) relié au curseur de déplacement (4) ; le manchon coulissant de déplacement (5) est en communication avec la cavité d'évaporation métallique (1), et le curseur de déplacement (4) coulisse le long du manchon coulissant de déplacement (5) sous une pression de la vapeur métallique ; une extrémité du ressort d'équilibrage de pression (6) est reliée au curseur de déplacement (4), et l'autre extrémité est reliée au système de détection de déplacement ; et le mécanisme de détection de pression (3) détermine la pression de la vapeur métallique en fonction de coordonnées du curseur de déplacement (4) détectées par le système de détection de déplacement, et **en ce que** le système de génération de déplacement comprend en outre un élément chauffant (9) disposé dans le manchon coulissant de déplacement (5).

2. Appareil de détection de pression de vapeur métallique selon la revendication 1, dans lequel le système de détection de déplacement comprend en outre un support fixe (7) et un capteur de déplacement (8) ; le support fixe (7) est pourvu d'un bloc de limitation à ressort (7-1) relié au ressort d'équilibrage de pression (6), d'une bague de fixation (7-3) emmanchée sur le manchon coulissant de déplacement (5), et d'un bloc de fixation de capteur (7-2) pour monter le capteur de déplacement (8) ; et le bloc de limitation à ressort (7-1) est disposé entre la bague de fixation (7-3) et le bloc de fixation de capteur (7-2), et le bloc de limitation à ressort (7-1) est pourvu d'un trou de transmission de lumière correspondant au capteur de déplacement (8).

3. Appareil de détection de pression de vapeur métallique selon la revendication 1, dans lequel le ressort d'équilibrage de pression (6) est composé de 1 à 10 ressorts, ayant un diamètre de fil de 0,1 à 6 mm.

4. Appareil de détection de pression de vapeur métallique selon la revendication 2, dans lequel un centre du capteur de déplacement (8), un centre du trou de transmission de lumière et un centre du ressort d'équilibrage de pression (6) sont sur le même axe.

5. Appareil de détection de pression de vapeur métallique selon la revendication 2, dans lequel le mécanisme de détection de pression comprend en outre un module de traitement intelligent ; et le module de traitement intelligent est utilisé pour recevoir les coordonnées du curseur de déplacement (4) détectées par le capteur de déplacement (8), pour calculer un déplacement du curseur de déplacement (4), et pour obtenir la pression de la vapeur métallique en fonction du déplacement du curseur de déplacement (4) et une courbe de relation entre le déplacement et une pression obtenue par étalonnage.

6. Procédé de détection de pression de vapeur métallique, dans lequel l'appareil de détection de pression de vapeur métallique selon l'une des revendications 1 à 5 est utilisé pour détecter une pression de vapeur métallique, dans lequel le procédé de détection comprend les étapes consistant à :

S1, introduire du gaz à différentes pressions dans une cavité d'évaporation métallique (1) de l'appareil de détection de pression de vapeur métallique pour un étalonnage répété afin d'obtenir une courbe de relation entre une pression et un déplacement d'un curseur de déplacement (4) ;
S2, faire fondre et évaporer un métal pour former de la vapeur métallique dans la cavité d'évaporation métallique (1), dans lequel le curseur de déplacement (4) coulisse le long d'un manchon coulissant de déplacement (5) sous une pression de la vapeur métallique, et un ressort d'équilibrage de pression (6) se contracte progressivement sous extrusion du curseur de déplacement (4) jusqu'à ce que le curseur de déplacement (4) atteigne un équilibre de force et arrête de bouger, et un système de détection de déplacement détecte des coordonnées du curseur de déplacement (4) en temps réel pour obtenir un déplacement du curseur de déplacement (4) ; et
S3, obtenir la pression de la vapeur métallique en fonction de la courbe de relation entre la pression et le déplacement du curseur de déplacement (4) obtenue à l'étape S1 et du déplacement du curseur de déplacement (4) obtenu à l'étape S2.

7. Procédé de détection de pression de vapeur métallique selon la revendication 6, dans lequel, à l'étape S1, le gaz présente une pression de $1 \times 10^3$ à $1 \times 10^5$ Pa.

8. Procédé de détection de pression de vapeur métallique selon la revendication 6, dans lequel, à l'étape S2, le déplacement $\Delta S$ du curseur de déplacement (4) est :

$$\triangle S = |S_t - S_0|$$

dans lequel $\triangle S$ est le déplacement du curseur de déplacement (4), en mm ;

$S_t$ représente des coordonnées du curseur de déplacement (4) lorsqu'il atteint un équilibre de force après déplacement, en mm ; et

$S_0$ représente des coordonnées du curseur de déplacement (4) à une position zéro, en mm.

9. Procédé de détection de pression de vapeur métallique selon la revendication 6, dans lequel, à l'étape S2, le manchon coulissant de déplacement (5) est chauffé par un élément chauffant (9) jusqu'à une température de 20 à 1000 °C pendant le mouvement du curseur de déplacement (4).

Figure 1

Figure 2a

## A-A

Figure 2b

Figure 3a

B-B

Figure 3b

Figure 4

Figure 5a

C-C

Figure 5b

Figure 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 112538603 A